(19) Europäisches Patentamt
European Patent Office
Office européen des brevets

(11) Publication number: **0 584 863 A1**

# (12) EUROPEAN PATENT APPLICATION

(21) Application number: **93202394.8**

(22) Date of filing: **16.08.93**

(51) Int. Cl.5: **C08G 59/18**, C08G 59/40, C08J 5/24, C08L 63/00

(30) Priority: **18.08.92 EP 92202539**

(43) Date of publication of application: **02.03.94 Bulletin 94/09**

(84) Designated Contracting States: **AT BE CH DE ES FR GB IE IT LI NL SE**

(71) Applicant: **SHELL INTERNATIONALE RESEARCH MAATSCHAPPIJ B.V.**
**Carel van Bylandtlaan 30**
**NL-2596 HR Den Haag(NL)**

(72) Inventor: **Bruynseels, Maria Julia**
**Avenue Jean Monnet 1**
**Louvain-la-Neuve, B-1348 Ottignies(BE)**
Inventor: **Yianni, Paul Antony**
**Avenue Jean Monnet 1**
**Louvain-la-Neuve, B-1348 Ottignies(BE)**

## (54) One pack self curable epoxy resin composition.

(57) The invention relates to a one pack self curable epoxy resin composition comprising

i) as epoxy component (a) at least one 1,2-epoxy resin compound having an average of more than one epoxy group per molecule and

ii) as curing component (b) at least one reaction product obtainable by reacting at elevated temperature dicyandiamide with a tetrabromobisphenol-A type epoxy resin, said resin having an epoxide equivalent weight of from 330 to 1500 and a bromine content of from 10 to 50% by weight, and

iii) as solvent (c) at least one compound being selected from the group represented by the general formula (I)

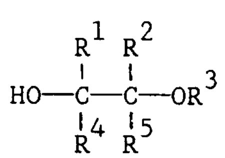

(I)

wherein $R^1$, $R^2$, $R^4$ and $R^5$ each individually represent hydrogen or $C_{1-3}$ alkyl, provided at least one of them is $C_{1-3}$ alkyl, and $R^3$ represents $C_{1-3}$ alkyl.

EP 0 584 863 A1

The invention relates to a one pack self curable epoxy resin composition which is particularly useful in the preparation of laminates for printed circuit boards (PCB's).

The National Electrical Manufactures Association (NEMA) specifies different types of printed circuit boards (PCB's). The most important specification for PCB's, which are manufactured using epoxy resin formulations, is the FR-4 specification.

The basic structure of an FR-4 PCB is a laminate, an inorganic matrix of woven glass fabric and a cured (cross linked) epoxy resin formulation.

The production of FR-4 laminates proceeds in two steps.

Firstly a continuous web of glass fabric passes through a bath comprising an epoxy resin formulation i.e. a solvent borne epoxy resin, a curing agent and an accelerator. The web then passes through a heater where the impregnated glass cloth is dried and the resin is partially cured to a "B" stage or prepreg. This process is carried out on a machine called a "treater". In the second step, different layers of prepreg are pressed between copper foil and cured by heating to give a copper clad laminate. The presently preferred curing agent in FR-4 resins is dicyandiamide (dicy).

Epoxy resin formulations for use in laminates for PCB's comprising dicy as curing compound generally give good chemical and physical properties such as good adhesion between sheets of glass cloth (interlaminar shear) and between the laminate and the copper foil (copper peel strength), they give prepregs which are stable, dry and have a wide processing window which allows easy production of prepreg, they give acceptable glass transition temperature (Tg) values in the cured laminates and dicy is a cheap chemical.

However there are two main problems associated with the use of dicy.

Firstly at room temperature dicy is poorly soluble therefore strong polar/hazardous solvents are required to prevent crystallisation of dicy when used in epoxy resin formulations. The term hazardous will be used throughout this specification to classify solvents which have a Threshold Limit Value (TLV) of less than 50 ppm. For example in European patent No. 133,600 ethyleneglycolmonomethyl ether (MeOx, TLV of 5 ppm) is being used to dissolve a dicy/accelerator mixture and in US Patent No. 4,756,954 a solvent blend comprising dimethylformamide (DMF, TLV of 10 ppm) is used to dissolve dicy.

From the Health Safety and Environmental (HSE) lobby there is considerable pressure to minimise and if possible to eliminate the use of hazardous solvents in the PCB fabrication process, such hazardous solvents include for example DMF (TLV of 10 ppm), dimethylsulfoxide (DMSO), ethyleneglycolmonomethylether (MeOx, TLV of 5 ppm), ethyleneglycolmonoethylether (EtOx, TLV of 5 ppm), ethyleneglycolisopropylether (iPrOx, TLV of 25 ppm), ethyleneglycolmonobutylether (BuOx, TLV of 20 ppm), and 2-ethoxyethanol acetate (TLV of 5 ppm).

Secondly, even when using epoxy resin formulations which comprise dicy and a hazardous solvent in order to dissolve dicy, in practice a lot of care should be taken in respect of the choice of the particular solvent, the ratio of the components in the epoxy resin formulation and the treater temperature, in order to minimise the relatively great chance upon the formation of microscopic crystals of dicy in the prepreg, causing staining problems in the PCB which may only become apparent after etching or after soldering of the devices. So, in view of the two problems touched upon above associated with the use of dicy as curing compound in epoxy resin formulations which are particularly suitable for use in the production of PCB's, it is an object of the present invention to provide an epoxy resin formulation, particularly suitable for use in the production of PCB's, which does not comprise hazardous solvents and wherein a reduced tendency of crystal formation of the curing compound is being observed at any stage of the processing of said epoxy resin composition in the PCB fabrication process, whilst providing good physical and chemical properties to laminates prepared therewith.

Accordingly, the present invention relates to a one pack self curable epoxy resin composition comprising:

i) as epoxy component (a) at least one 1,2-epoxy resin compound having an average of more than one epoxy group per molecule and

ii) as curing component (b) at least one reaction product obtainable by reacting at elevated temperature dicyandiamide with a tetrabromobisphenol-A type epoxy resin, said resin having an epoxide equivalent weight of from 330 to 1500 and a bromine content of from 10 to 50% by weight, and

iii) as solvent (c) at least one compound being selected from the group represented by the general formula (I)

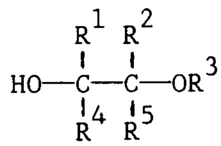

(I)

wherein $R^1$, $R^2$, $R^4$ and $R^5$ each individually represent hydrogen or $C_{1-3}$ alkyl, provided at least one of them is $C_{1-3}$ alkyl, and $R^3$ represents $C_{1-3}$ alkyl.

With the one pack system of the invention laminates for PCB manufacture can be prepared which meet typical FR-4 electrical standards and which show good physical and chemical properties such as for example a high Tg in the cured state and the absence of crystal formation. The solvents of the above formula I are, in the context of this specification, non hazardous solvents, thus providing the HSE advantage aimed at, and surprisingly provide sufficient solubility at room temperature for the curing component (b) based on the reaction product of dicy and a tetrabromobisphenol-A type epoxy resin. It was shown that compositions similar to the one pack system of the invention except for the use of dicy instead of curing component b), were simply not useable due to precipitation of dicy at room temperature.

Virtually any 1,2-epoxy resin compound known in the art for use in epoxy resin compositions for use in the preparation of laminates for PCB's, or mixtures thereof may be used in epoxy component (a). Well known examples are the, optionally halogenated, polyglycidylethers of bisphenol-A. Other polyepoxides known in the art can be used too, these include the polyether polyepoxides obtainable by reacting epihalohydrin with a polyhydric phenolic compound such as resorcinol, bisphenol, bisphenol-F or with a polyhydric alcohol such as ethylene glycol, glycerine, hexanetriol, trimethylolpropane, pentaerithritol and polyethyleneglycol; the polyester polyepoxides obtainable by reacting an epihalohydrin with polycarboxylic acids such as succinic acid, glutaric acid, and the various isomers of phthalic acid; the epoxydated novolacs and polyepoxides derived from the epoxidation of organic compounds containing two or more aliphatic double bonds including for example 3,4-epoxycyclohexane carboxylate; and the urethane modified polyepoxides.

Particularly suitable 1,2 epoxy compounds are the optionally halogenated epoxy novolaks and the optionally halogenated polyglycidylethers of resorcinol, bisphenol-A, bisphenol-F, bisphenol and the fusion products thereof, or blends of the aforesaid 1,2-epoxy compounds. The most preferred 1,2-epoxy compounds used in the one pack system of the invention are epoxy resins based on bisphenol-A and tetrabromobisphenol-A.

Examples of suitable commercially available bisphenol-A type epoxy resins are Epikote 828 (Epoxy Group Content, EGC of from 5150 to 5490 mmol/kg), Epikote 834 (EGC of from 3570-4440 mmol/kg) and Epikote 1001 (EGC of from 2000-2220 mmol/kg). Suitable tetrabromobisphenol-A epoxy resins are the same ones as the tetrabromobisphenol-A type epoxy resins as mentioned below suitable for the preparation of the adduct in curing component (b). Preferred commercially available tetrabromobisphenol-A type epoxy resins are Epikote 1141 and Epikote 1161 as defined below under the heading materials (Epikote is a tradename).

If desired blends of halogenated and non halogenated epoxy resins may also be used as epoxy component (a), their relative amounts will depend on the desired characteristics of the final composition such as the desired level of fire retardancy.

As curing component (b), at least one reaction product (adduct) of dicy and a tetrabromobisphenol-A type epoxy resin is being used. Blends of different dicy-tetrabromobisphenol-A type adducts may also be used as curing component b). The preferred temperature for adduct formation ranges of from 50 to 220 °C.

Adduct formation takes place as a result of the reaction between the primary amine group of dicy and an epoxy group of a tetrabromobisphenol-A type molecule. The net result of this reaction is the loss of the primary amine - and the epoxy group and the gain of a secondary amine group and a free hydroxyl group.

Evidence for this adduct formation has been obtained by means of proton - and carbon Nuclear Magnetic Resonance (NMR) and Infrared - and Mass spectroscopy. It will be understood that adduct formation has been completed when essentially no further reaction between a primary amine group and an epoxy group is possible in the reaction mixture.

Adduct formation may be carried out in the absence or in the presence of a solvent. When adduct formation is carried out in the absence of a solvent usually a temperature of at least 175 °C will be required in order to obtain a homogenous melt of dicy and the tetrabromobisphenol-A type epoxy resin and to trigger the reaction between a primary amine and an epoxy group.

When adduct formation takes place in the absence of a solvent than dicy and the tetrabromobisphenol-A type epoxy resin should be reacted in relative amounts so as to provide of from 0.5 to 1.5, preferably of from 0.8 to 1.2 primary amine groups per epoxy group. The upper limit of 1.5 primary amine group(s) per epoxy group should be adhered to in order to prevent the presence of a too high level of free dicy in the adduct formed.

The lower level of 0.5 has been selected in order to ensure that at least an adduct of one mole of dicy and one mole of epoxy resin is being formed. It is preferred however to prepare an adduct of 2 moles of dicy and one mole of the tetrabromobisphenol-A type epoxy resin, thus providing essentially equimolar amounts of the primary amine and the epoxy groups to the reaction mixture.

It is preferred, however, to prepare the adduct in the presence of a solvent, particularly in view of the lower temperatures which may be applied and in view of the possibility to remove unreacted dicy, if present, from the reaction mixture at completion of adduct formation as will be further explained below. Essentially, any solvent known in the art for use in curable compositions comprising dicy as curing compound such as those disclosed in US patent No. 2,928,811 may be used for adduct formation.

However, from the HSE point of view, as well as for practical reasons it is preferred to prepare the adducts in a solvent selected from the group represented by the above general formula I whereof the preferred ones are the same as the preferred solvents (c) discussed below. A preferred route for adduct formation in the presence of a solvent is the following.

Firstly dicy is heated in a suitable amount of solvent(s) at a temperature in the range of from 50 to 120 °C, while stirring, whereafter the brominated bisphenol-A type epoxy resin, suitably dissolved in - or diluted with a desired amount of the same or a different solvent used to dissolve dicy, is added gradually. Then the reaction between the brominated bisphenol-A type epoxy resin and dicy is allowed to take place, while stirring and keeping the reaction mixture at elevated temperature, for a desired period of time, usually of from 0.5 to 3.0 hours. At completion of the reaction, the reaction mixture may be used directly for the preparation of the one pack self curable epoxy resin composition of the invention, may be cooled and stored for use at a later stage or the adduct may be recovered from the hot reaction mixture according to methods known in the art, suitably by cooling the reaction mixture followed by isolating, washing and drying of the precipitated product. The adduct is preferably stored in the presence of a stabilizer and preferably in a solvent. Suitable stabilizers are acids such as for example maleic-, malonic-, citric-, succinic-, salicylic-, lactic-, oxalic- or para toluene sulphonic acid, paratoluene sulfonic acid being particularly preferred.

It may be required to isolate the adduct from the reaction mixture at the end of the reaction before it is being used in the one pack system of the present invention. This would be the case for example when the adduct is being prepared using DMF as solvent, or when dicy and the tetrabromobisphenol-A type epoxy resin are reacted so as to provide of from 1.5 to 4 primary amine group(s) per epoxy group. When it is not necessary to isolate the adduct from the reaction mixture, and the adduct is either used directly for the preparation of the one pack system of the invention or stored for later use as such, dicy and the tetrabromobisphenol-A type epoxy resin are reacted so as to provide of from 0.5 to 1.5, preferably of from 0.8 to 1.2 primary amine group(s) per epoxy group, in order to prevent the presence of a too high amount of free dicy in the one pack system.

Similarly, as in the case of adduct formation in the absence of a solvent, when carrying out adduct formation in the presence of a solvent it is preferred to prepare an adduct of 2 moles of dicy and one mole of the tetrabromobisphenol-A type epoxy resin, thus providing essentially equimolar amounts of the primary amine and the epoxy groups to the reaction mixture. The adduct can be isolated from the reaction mixture according to methods known in the art.

It was found that isolation of the adduct from the hot reaction mixture using DMF as solvent is fairly simple, since upon cooling of the reaction mixture by addition of ice-water the adduct precipitates at an earlier stage than the free dicy in the reaction mixture, if present. An adduct thus may be isolated which is essentially free of unreacted dicy molecules, comprising less than 10 mole percent of free dicy, based on the amount of free dicy present in the reaction mixture at completion of the reaction before cooling.

The amount of solvent used in the adduct formation depends on the particular reaction conditions applied, but as a general rule should be sufficient to provide an adequate solution of all components during the reaction.

The adduct formation may take place in the presence or in the absence of a catalyst. The use of a catalyst however is generally preferred, since it tends to reduce reaction time and/or reaction temperature. In principle any catalyst known in the art suitable for the promotion of the reaction between the primary amine (of dicy) and an epoxy group (of the tetrabromobisphenol-A type epoxy resin) can be used. Examples of suitable catalysts are the imidazoles, amines, ammoniumsalts, phosphines and posphonium salts.

2-methylimidazole is a preferred catalyst. Suitably the amount of catalyst used in adduct formation lies in the range of from 0.001 to 1.0 parts by weight (pbw) per 100 pbw of tetrabromobisphenol-A type epoxy resin solids.

The tetrabromobisphenol-A type epoxy resin used for the preparation of curing component (b) as defined above may be based on tetrabromobisphenol-A or on the diglycidylether of tetrabromobisphenol-A.

Examples of suitable tetrabromobisphenol-A type epoxy resins based on tetrabromobisphenol-A are reaction products (or so called advanced products) of

- tetrabromobisphenol-A with
- one or more suitable epoxy resin compound(s) such as for example (advanced) epoxy resins produced from bisphenol-A and/or bisphenol-F and epichlorohydrin, or polyglycidylethers of polyfunctional phenolic compounds such as those disclosed in European patent application publication number 549080, and optionally
- with one or more suitable other polyhydroxyaromatic compounds, such as for example bisphenol-A or bisphenol-F.

Examples of suitable tetrabromobisphenol-A type epoxy resins based on the diglycidylether of tetrabromobisphenol-A are the diglycidylether of tetrabromobisphenol-A or the reaction products (or so called advanced products) of:

- the diglycidylether of tetrabromobisphenol-A with
- one or more suitable polyhydroxyaromatic compounds such as for example bisphenol-A, bisphenol F and the polyfunctional phenolic compounds as disclosed in EP-A-549080 and optionally
- with one or more suitable other epoxy resin compounds, such as for example the diglycidylether of bisphenol-A or bisphenol-F.

Preferred tetrabromobisphenol-A type epoxy resins have a bromine content of from 18 to 22 percent by weight and an epoxy group content of from 1739 to 3030 mmol/kg.

The fact that the dicy-brominated bisphenol-A type epoxy resin adducts used in curing component (b) do not require the use of hazardous solvents to dissolve them is considered a particular advantageous aspect of the present invention.

Those skilled in the art will recognize that the amount of component (b) used in the one pack system according to the invention is empirical and will vary according to the particular components (a) and (b) and solvents (c) being used and in general should be sufficient to provide full cure under normal dicy cured brominated resin reaction conditions which are for example a first cycle of from 1 to 10 minutes at 150 to 250 °C for the preparation of a prepreg followed by a second cycle of from 0.5 to 3 hours at 150 to 200 °C to cure the prepreg.

Suitable solvents (c) according to the general formula I for use in the one pack system of the present invention are propyleneglycolmonomethylether (Meprox), a compound of the general formula I wherein $R^3$ and $R^4$ are methyl and $R^1$, $R^2$ and $R^5$ are hydrogen, propyleneglycolmonoethylether (Etprox), a compound of the formula I wherein $R^3$ is ethyl, $R^4$ is methyl and $R^1$, $R^2$ and $R^4$ are hydrogen and propyleneglycol-mono-n-propylether a compound of the formula I wherein $R^3$ is n-propyl, $R^4$ is methyl and $R^1$, $R^2$ and $R^5$ are hydrogen.

The currently most preferred solvent (c) according to the general formula I is propyleneglycolmonomethylether and is commercially available under the tradename methylproxitol available from Shell Chemical Company (Proxitol is a tradename). Meprox provides excellent solubility is relatively non toxic i.e. it has a Theshold Limit Value (TLV) of (100 ppm), which is about 20 times the TLV of MeOx (TLV 5 ppm) and about 10 times the TLV of DMF (TLV 10 ppm). The amount of solvent (c) used in the one pack system of the invention should be sufficient to enable adequate dissolution of the respective components of the one pack system and may vary according to the desired viscosity and solids content of the one pack composition. The solvent (c) may comprise other solvents than those according to the general formula I, provided they are non-hazardous and the weight ratio of solvent (c) to other solvent is higher than 2 preferably higher than 5. Examples of these other non hazardous solvents are: acetone, methyl ethylketone, methylacetate, n-propylacetate, ethylacetate, i-propylacetate and i-butylacetate. The amount of solvent (c) used in the one pack system of the present invention suitably lies in the range of from 30 to 200 pbw, preferably of from 50 to 200 pbw, per 100 pbw of the components (a) plus (b).

The one pack system of the invention is suitably prepared by adding the epoxy component a), optionally dissolved in part of the solvent c), to curing component b), which has been dissolved in part of the solvent c), usually at slightly elevated temperature e.g up to 50 °C. If the one pack system is to be stored for later use the stability c.q. shelf life thereof may be improved by addition thereto of one or more acid compounds such as for example maleic-, malonic-, citric-, succinic-, salicylic-, lactic-, oxalic- or para toluene sulphonic acid.

In order to promote cure a curing accelerator may be added to the one pack system of the invention shortly before use. Suitable curing accelerators are for example tertiary phosphines and phosphine salts, tertiary amines and amine salts, amine complexes and imidazole compounds or mixtures thereof. The most preferred accelerators are the imidazole compounds, mostly preferred is 2-methyl imidazole.

It will be understood that gel times may be adjusted to any value by incorporation of the appropriate concentration of the accelerator.

If desired one or more co-curing compounds, such as those described in US patent No. 4,559,395 may be added to the one pack system of the invention.

The one pack system of the invention may further contain if desired other additives including fillers such as for example silica, alumina and aluminium hydroxide, fire retardants such as for example antimony trioxide, colouring agents, surface processing agents such a silane coupling agents and release agents.

Curing times and cure temperatures of the one pack system of the invention will depend on its particular constituents, but will normally lye in the range of from 30 to 300 minutes and of from 100 to 250 °C respectively.

As already indicated above the one pack system of the invention is particularly suitable for the preparation of laminates for PCB manufacture, more in particular FR-4 PCB's but may also be useful in other applications such as electrical applications and in structural laminates or composites. Suitable substrates which can be employed herein are for example glass, graphite, aromatic polyamides, carbon, quartz, ceramic, synthetic and natural fibres combinations thereof in woven, mat or fibrous form.

The invention is illustrated by the following examples:

Materials:

Epikote 1141 is an epoxy resin compound, having an EGC of from 1900 to 2200 mmol/kg and a bromine content of from 20-22 %w (calculated), prepared by advancing Epikote 828 with tetrabromobisphenol-A.

Epikote 828 EL is an epoxy resin produced from bisphenol-A and epichlorohydrin, having a low hydrolyzable chlorine content and having an EGC of from 5260 to 5380 mmol/kg.

Epikote DX 90 is a multifunctional epoxy resin based on bisphenol-A having an EGC of from Epikote 1161 is a co-fusion resin based on Epikote 828, Epikote DX 90 and tetrabromobisphenol-A, having an EGC of 2200 mmol/kg and a bromine content of 20 %w.

Dicyandiamide (dicy) was supplied by SKW, Trostberg, Germany.

Tetramethylammonium chloride (TMAC) was supplied by FLUKA chemie AG, Switzerland.

2-methylimidazole (2-MI) was supplied by BASF, Germany.

Dimethylformamide (DMF), methylproxitol (MeProx), methyloxitol (MeOx) and ethyloxitol (EtOx) technical grades were used in the solubility studies and in the preparation of varnishes.

Infrared Spectoscropy was performed with a Nicolet 20 SXC FT-IR spectrometer.

Reactivity determinations were made using the Hot Plate Gel Time technique at 170 °C.

Glass transition temperatures of the cured (170 °C for 1 or 2 hours) laminates were measured by a DSC Perkin-Elmer 7 apparatus with a heating rate of 10 °C/min.

Solubility studies in various solvents were carried out as follows:

The amount in grams (g) of product which could be added to 100 grams of solvent at 20 °C while stirring till saturation.

Preparation of resin impregnated glasscloth (prepreg):

Glass fabric, type Marglass 274 (7628 style- 200 g/m) with an epoxy silane finish was impregnated by hand with the epoxy resin composition (aged for 1 hour at room temperature) until saturation and was partially cured to the "B" stage for 2 minutes at 170 °C.

Evaluation of the prepreg;

The "B" stage prepreg samples were evaluated under a microscope (20 times magnification). They were rated from 0 to 4 depending on the level of crystallisation of the curing compound. Rating 0 means that no crystals were observed in the prepreg, whereas rating 4 indicates the presence of a very high level of crystals in the prepreg.

Example 1

Process for the preparation of adducts $Y_1$, $Y_2$ and $Y_3$.

The amount of dicy was placed together with the required amount of solvent in a 500 ml glass reaction vessel equipped with a reflux condenser magnetic stirrer and a thermocouple. The mixture was heated while stirring in a temperature controlled silicon oil bath. When all the dicy was dissolved the required amount of catalyst was added. When the temperature had reached the desired level the amount of epoxy resin optionally dissolved in a desired amount of solvent was added dropwise. After the total addition (over ca. 90 minutes) the reaction mixture was stirred for further 30 min. at the same temperature.

The mixtures $X_1$, $X_2$ and $X_3$ were allowed to cool down to 100 °C and 800 ml of ice water was added. The precipitated product was filtered off and washed several times with water. Finally the product was dried in a forced air draft oven at a temperature of 50 °C. The resulting products are coded "Y".

Table 1 gives some process characteristics of the formation of $Y_1$, $Y_2$ and $Y_3$ and their solubility in various solvents, if determined. The solubility of dicy alone is presented for comparison.

The data presented in table 1 show that reaction products $Y_1$ and $Y_2$ have a far better solubility than dicy.

Example 2

* Preparation of a one pack self curable epoxy resin composition of the invention 1.

290 pbw of $Y_1$ was dissolved in 390 pbw of methylproxitol while heating to 100 °C. When all $Y_1$ was dissolved the heating was turned off and 1638 pbw of a 70% solution of Epikote 1141 in methylproxitol was added, followed by addition of methylproxitol till a solids content of 60% and addition of acetone in order to obtain a final solids content of 55%.

* Preparation of a one pack self curable epoxy resin compositions of the invention 2.

1171 pbw of a 70% solution of Epikote 1141 in methylproxitol was added to the hot reaction mixture "$X_2$" as produced in example 1, followed by addition of methylproxitol till a solids content of 60% and addition of acetone in order to obtain a final solids content of 55%.

* Preparation of the one pack self curable resin compositions 3 and 4 of the invention.

0.86 pbw of paratoluenesulfonic acid monohydrate and 12.9 pbw of methylproxitol was added to 48.7 pbw of the hot reaction mixture "$X_2$" as produced in example 1. The final solids content being 35% by weight.

Composition 3 was prepared by adding to the above blend 102.5 pbw of a blend of Epikote 828EL and tetrabromobisphenol-A (weight ratio 66:34) dissolved in methylethylketone up to 80% by weight solids, followed by addition of 0.55 pbw of 2-methylimidazole.

Alternatively composition 4 was prepared by adding to the above blend 102.5 pbw of a blend of Epikote 828EL, Epikote DX90 and tetrabromobisphenol-A (weight ratio of 42/24/34) dissolved in methylethylketone up to 80% by weight solids, followed by addition of 0.1 pbw of 2-methylimidazole.

* Preparation of the one pack self curable resin composition 5 of the invention.

0.86 pbw of paratoluenesulfonic acid monohydrate and 12.9 pbw of methylproxitol was added to 48.7 pbw of the hot reaction mixture $X_3$ as produced in example 1. The final solids content being 35% by weight.

Next, 109.3 pbw of a 75% by weight solids solution of EPIKOTE 1161 in methylproxitol was added followed by addition of 0.55 pbw of 2-methylimidazole.

Comparative Example 1

Preparation of comparative epoxy resin compositions 1 and 2 comprising dicy/epoxy resin blends.

The same components in similar amounts as used for the preparation of $Y_1$ and $Y_2$ in example 1 were placed together in a reaction vessel equipped with a magnetic stirrer. After 30 min stirring at room temperature 1638 and 1171 pbw respectively of a 70% solution of Epikote 1141 in methylproxitol was

added and the resulting blend was diluted with methylproxitol until a solids content of 60% and further diluted with acetone till a solids content of 55%.

Preparation of comparative epoxy resin composition 3 comprising dicy as curing compound.

42.9 pbw of a 7% solution of dicy in methyloxitol was mixed with 2 pbw of a 10% solution of 2-methylimidazole in methylproxitol and with 100 pbw of Epikote 1141 dissolved in a solvent blend of 15.6 pbw of acetone and 4.33 pbw of methylproxitol.

Example 3

Evaluation of the one pack self curable epoxy resin compositions of the invention 1 to 5 and of comparative epoxy resin compositions 1 to 3.

The one pack self curable epoxy resin compositions of the invention comprise relatively non hazardous solvents only which is a real advantage when compared to comparative epoxy resin composition 5 wherein the use of (hazardous) methyloxitol was required to dissolve dicy.

FTIR spectroscopy of the one pack self curable epoxy resin compositions 1 to 5 of the invention and of comparative epoxy resin compositions 1 and 2 showed a clear difference. Absorption peaks at 2825 nm from a secondary amine group and at 1080 nm from a secondary hydroxyl group are clearly present in spectra of compositions of the invention and absent in spectra of comparative epoxy resin compositions. Said absorption peaks presumably derive from the dicy-Epikote 1141 adducts prepared in example 1. The reaction between each of the epoxy groups of the epoxy resin compound with a primary amine group of a dicy molecule results in the formation of a secondary amine group and a secondary hydroxyl group.

In table 2 data are presented resulting from the evaluation of the one pack self curable epoxy resin compositions of the invention and of the comparative compositions.

No crystals were observed in prepregs prepared with the one pack self curable epoxy resin compositions of the invention 1 to 5, whereas the crystallisation levels observed in the prepregs prepared with comparative compositions 1 and 2 are unacceptably high.

The prepreg prepared with comparative composition 3 shows a low crystallisation level, however this composition was prepared using methyloxitol for dissolving dicy.

Further from table 2 it becomes clear that the one pack self curable resin compositions of the invention have good levels of reactivity and Tg, in particular compositions 3 to 5.

TABLE 1 *

| Product | $Y_1$ | $Y_2$ | $Y_3$ | DICY |
|---|---|---|---|---|
| DICY | 30 | 30 | 30 | |
| Solvent for DICY | | | | |
| DMF | 73 | | | |
| MeProx | | 200 | 200 | |
| Catalyst | | | | |
| TMAC | 0,2 | | | |
| 2-MI | | 0.2 | 0.2 | |
| EPIKOTE 1141 | 180 | 180 | | |
| EPIKOTE 1161 | | | 180 | |
| Solvent for epoxy resin | | | | |
| DMF | 124 | | | |
| MeProx | | 77 | 77 | |
| Reaction T (°C) | 135-140 | 110-120 | 100 | |
| Solubility ** | | | | |
| DMF | > 80 | > 80 | N.D. | 27.2 |
| MeOx | 50 | 50 | N.D. | 12-13 |
| EtOx | > 60 | > 60 | N.D. | 7.5 |
| MeProx | > 15 | > 15 | N.D. | 6 |

* All amounts given in pbw.

** Solubility of isolated dried curing compound Y, in %w at 20 °C.

N.D. stands for not determined.

TABLE 2

| | | According to invention | | | | | For comparison | | |
|---|---|---|---|---|---|---|---|---|---|
| Epoxy Resin composition | | 1 | 2 | 3 | 4 | 5 | 1 | 2 | 3 |
| Crystallisation rating | | 0 | 0 | 0 | 0 | 0 | 4 | 4 | 1 |
| Reactivity (s) | | 142 | 200 | 130 | - | - | 198 | 220 | 203 |
| Tg (°C) | 1h, 170 °C<br>1h, 170 °C | 134 | 135 | 141<br>142 | -<br>148 | 145<br>144 | 129 | 120 | 134 |

## Claims

**1.** A one pack self curable epoxy resin composition comprising

i) as epoxy component (a) at least one 1,2-epoxy resin compound having an average of more than one epoxy group per molecule and

ii) as curing component (b) at least one reaction product obtainable by reacting at elevated temperature dicyandiamide with a tetrabromobisphenol-A type epoxy resin, said resin having an epoxide equivalent weight of from 330 to 1500 and a bromine content of from 10 to 50% by weight, and

iii) as solvent (c) at least one compound being selected from the group represented by the general formula (I)

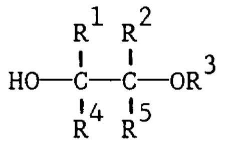

(I)

wherein $R^1$, $R^2$, $R^4$ and $R^5$ each individually represent hydrogen or $C_{1-3}$ alkyl, provided at least one of them is $C_{1-3}$ alkyl, and $R^3$ represents $C_{1-3}$ alkyl.

**2.** A composition as claimed in claim 1 wherein component (a) comprises at least a compound selected from the group consisting of the optionally halogenated epoxy novolaks, the optionally halogenated polyglycidylethers of resorcinol, bisphenol-A, bisphenol-F and bisphenol or fusion products thereof or blends of the aforesaid compounds.

**3.** A composition as claimed in claim 1 or 2 wherein component (a) comprises at least one compound selected from the group consisting of the bisphenol-A type or the tetrabromobisphenol-A type epoxy resins or fusion products thereof.

**4.** A composition as claimed in any one of the claims 1 to 3 wherein component (a) comprises a tetrabromobisphenol-A epoxy resin compound having an epoxy group content of from 1900-2200 mmol/kg and a bromine content of from 20 to 22% by weight.

**5.** A composition as claimed in any one of the claims 1 to 4 wherein the reaction between dicy and the tetrabromobisphenol-A type epoxy resin is carried out at a temperature lying in the range of from 50 to 160 °C, in the presence of a solvent (c) and wherein dicy and the tetrabromobisphenol-A type epoxy resin are reacted in relative amounts so as to provide of from 0.5 to 1.5 amine group(s) per epoxy group.

**6.** A composition as claimed in any one of the claims 1 to 5 wherein the reaction between dicy and the tetrabromobisphenol-A type epoxy resin is carried out at a temperature lying in the range of from 50 to 160 °C, in the presence of a solvent and wherein dicy and the tetrabromobisphenol-A type epoxy resin are reacted in relative amounts so as to provide of from 0.5 to 4.0 amine group(s) per epoxy group, and the reaction product formed is isolated from the hot reaction mixture.

**7.** A composition as claimed in any one of the claims 1 to 6 wherein the tetrabromobisphenol-A type epoxy resin used in the preparation of curing component (b) has of from 1 to 4 epoxy groups per molecule, a bromine content of from 18 to 22 percent by weight and an epoxy group content of from 1739 to 3030 mmol/kg.

**8.** A composition as claimed in any one of the claims 1 to 7 wherein the solvent (c) is propyleneglycolmonomethylether.

**9.** A composition as claimed in any one of the claims 1 to 8 further comprising one or more non-hazardous solvent(s) in an amount so that the weight ratio of solvent (c) to other solvent(s) is higher than 5.

**10.** A substrate impregnated with a curable composition as claimed in any one of the claims 1 to 9.

**11.** An impregnated substrate of claim 10 wherein said substrate is glass of graphite in woven, mat or fibrous form.

**12.** A laminate prepared from one or more layers of the impregnated substrate of claim 10 or 11.

**13.** Use of a composition as claimed in any one of the claims 1 to 9 in a method for producing a printed circuit board.

European Patent Office

# EUROPEAN SEARCH REPORT

Application Number
EP 93 20 2394

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| Y | CHEMICAL ABSTRACTS, vol. 86, no. 18, 2 May 1977, Columbus, Ohio, US; abstract no. 122376y, 'Hardening agent for epoxy resins' page 44 ; * abstract * & CS-A-165 217 (WIESNER I.) 15 October 1976 | 1-13 | C08G59/18<br>C08G59/40<br>C08J5/24<br>C08L63/00 |
| Y | IBM TECHNICAL DISCLOSURES BULLETIN vol. 30, no. 2 , July 1987 , ARMONK,NEW YORK,USA page 531 'Solvent blend for epoxy resin with dicyanamide' | 1-13 | |
| A | GB-A-2 054 602 (GENERAL ELECTRIC CO.) * claims 1,4,5; example 1 * | 1-4, 10-13 | |
| A | NL-A-254 742 (SHELL INTERNATIONAL RESEARCH MAATSCHAPPIJ N.V.) * claim 1 * | 1,4-7 | **TECHNICAL FIELDS SEARCHED (Int.Cl.5)**<br>C08G<br>C08L |
| A | DATABASE WPI Derwent Publications Ltd., London, GB; AN 88-357677(50) & JP-A-63 268 726 (DAICEL CHEM IND KK) 7 November 1988 * abstract * | 8 | |

The present search report has been drawn up for all claims

| Place of search | Date of completion of the search | Examiner |
|---|---|---|
| THE HAGUE | 2 December 1993 | O'Sullivan, T |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)